# EUROPÄISCHE PATENTSCHRIFT

(11) **EP 1 342 242 B1**
(45) Veröffentlichungstag und Bekanntmachung des Hinweises auf die Patenterteilung: **09.06.2004**
(21) Anmeldenummer: 01993931.3
(22) Anmeldetag: 12.11.2001
(51) Int. Cl.: G11C 11/16

(54) **MRAM-ANORDNUNG MIT AUSWAHLTRANSISTOREN GROSSER KANALWEITE**
MRAM ARRANGEMENT WITH SELECTION TRANSISTORS OF LARGE CHANNEL WIDTH
ENSEMBLE MRAM POURVU DE TRANSISTORS DE SELECTION A GRANDE LARGEUR DE CANAL

(30) Priorität: 13.11.2000 DE 10056159
(43) Veröffentlichungstag der Anmeldung: 10.09.2003
(73) Patentinhaber: Infineon Technologies AG, 81669 München (DE)
(72) Erfinder: BOEHM, Thomas, 85604 Zorneding (DE); HÖNIGSCHMID, Heinz, Essex Junction, VT 05452 (US); RÖHR, Thomas, Yokohama City 231-0838 (JP)
(74) Vertreter: Kottmann, Heinz Dieter, Dipl.-Ing.
(86) Internationale Anmeldenummer: PCT/DE2001/004232
(87) Internationale Veröffentlichungsnummer: WO 2002/039455

(56) Entgegenhaltungen:
- EP-A- 0 469 934
- US-A- 5 640 343
- US-B1- 6 169 688

## Beschreibung

Die vorliegende Erfindung betrifft eine MRAM-Anordnung (MRAM = Magnetoresistiver RAM) mit einer Vielzahl von in einem Speicherzellenfeld matrixartig vorgesehenen MTJ-Speicherzellen (MTJ = Magnetic Tunnel Junction bzw. magnetischer Tunnel-Übergang), die jeweils zwischen in einer ersten Richtung des Speicherzellenfeldes verlaufenden Bitleitungen und Plattenleitungen liegen, mit im Abstand von den MTJ-Speicherzellen angeordneten, diesen reihenweise zugeordneten und sich im Speicherzellenfeld in einer zweiten Richtung erstreckenden Digitleitungen, wobei die zweite Richtung im Wesentlichen senkrecht zur ersten Richtung ist, und mit an die Plattenleitungen angeschlossenen Auswahl- oder Isolationstransistoren, deren Gateanschlüsse mit Wortleitungen verbunden sind und die mit ihren Source-Drain-Strecken, zwischen den Plattenleitungen und Bezugspotential (Ground) liegen.

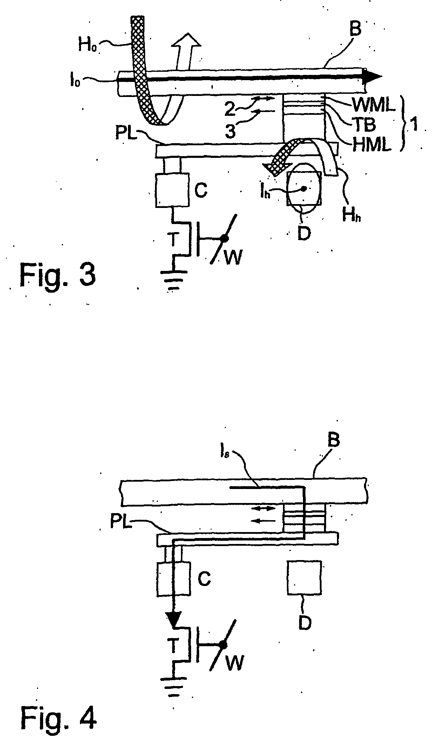

Fig. 3 zeigt eine MTJ-Speicherzelle 1, die zwischen einer Bitleitung BL und einer Plattenleitung PL liegt und aus einer weichmagnetischen Schicht WML, einer Tunnelbarrierenschicht TB und einer hartmagnetischen Schicht HML besteht. Die Orientierung der Magnetisierung der weichmagnetischen Schicht WML ist einstellbar, während die Orientierung der hartmagnetischen Schicht HML fest ist, wie dies durch einen Doppelpfeil 2 für die weichmagnetische Schicht WML und einen in der Fig. 3 nach links weisenden Pfeil 3 für die hartmagnetische Schicht HML angedeutet ist.

Unterhalb der MTJ-Speicherzelle 1 und elektrisch isoliert von dieser und von der Plattenleitung PL befindet sich eine Digitleitung D, durch die ein Programmierstrom Iₕ, der ein Magnetfeld Hₕ erzeugt, geschickt werden kann. Dieser Programmierstrom Iₕ wirkt mit einem Programmierstrom I₀ zusammen, welcher durch die Bitleitung BL zu fließen vermag und ein Magnetfeld H₀ erzeugt. Mindestens einer der beiden Programmierströme Iₕ und I₀ muss in seiner Richtung umkehrbar sein.

Die Plattenleitung PL ist über eine Verbindungsleitung C mit einem Auswahl- bzw. Tsolationstransistor T verbunden, dessen Gateelektrode an einer Wortleitung WL liegt und der mit seiner Source-Drain-Strecke zwischen der Verbindungsleitung C und Bezugspotential (Ground) gelegen ist.

Der Widerständswert der MTJ-Speicherzelle 1 ist zwischen der Bitleitung BL und der Plattenleitung PL bei paralleler Orientierung der Magnetisierungsrichtungen in der weichmagnetischen Schicht WML und der hartmagnetischen Schicht HML niedriger als bei antiparalleler Orientierung dieser Magnetisierungen. Demgemäß kann der eine Zustand mit paralleler Orientierung der Magnetisierungen beispielsweise als "1" bewertet werden, wenn dem Zustand einer aritiparallelen Orientierung der Magnetisierungen ein Wert "0" zugeordnet wird. Selbstverständlich ist auch eine umgekehrte Bewertung dieser Zustände möglich.

Zum Schreiben der MTJ-Speicherzelle 1 werden Programmierströme I₀ und Iₕ durch die Bitleitung BL sowie die Digitleitung D in solchen Richtungen geschickt, dass die durch diese Ströme er-zeugten Magnetfelder H₀ und Hₕ die Orientierung der Magneti-sierung der weichmagnetischen Schicht WML parallel oder anti-parallel zur Orientierung der Magnetisierung der hartmagnetischen Schicht HML einstellen. Bei diesem Schreibvorgang ist der Aus-wahltransistor T ausgeschaltet, indem beispielsweise bei einem n-Kanal-MOS-Transistor des Anreicherungstyps an, dessen Gate, also an die Wortleitung WL, ein Potential 0 angelegt wird.

Fig. 4 veranschaulicht, wie die MTJ-Speicherzelle 1 von'Fig. 3 ausgelesen wird: Hierzu wird der Auswahltransistor T eingeschaltet und ein Sense- bzw. Lesestrom Iₛ durch die Bitleitung BL, die MTJ-Zelle 1, die Plattenleitung PL, die Verbindungsleitung C und den Transistor T geschickt. Abhängig von der Größe dieses Stromes Iₛ, die am Eingang der Bitleitung BL festgestellt wird, wird der Speicherinhalt als eine "1" oder eine "0" bewertet.

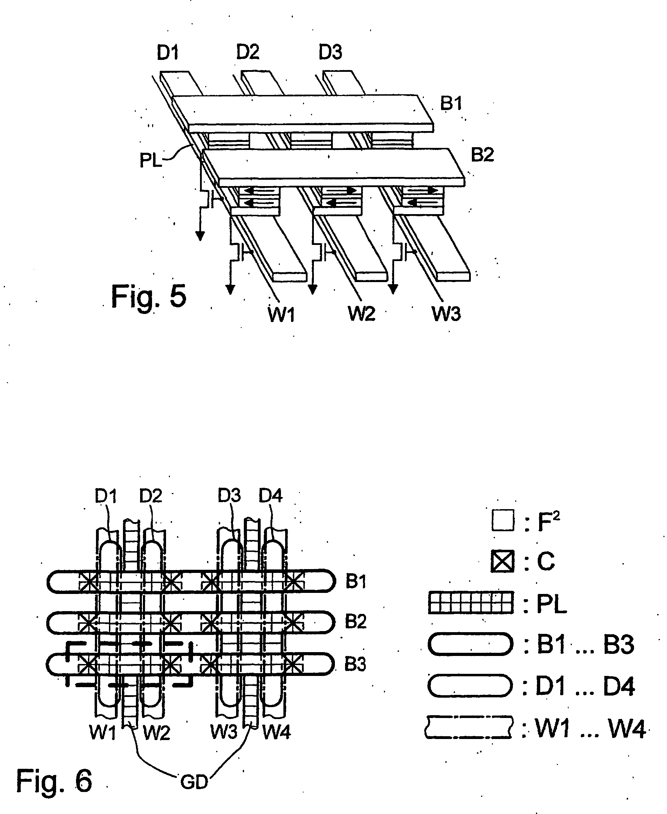

Fig. 5 zeigt ein Speicherzellenfeld mit MTJ-Speicherzellen 1 zwischen Bitleitungen B1, B2 und Digitleitungen D1, D2 und D3, wobei jeder MTJ-Speicherzelle 1 ein Auswahltransistor T zugeordnet ist und die Gates der Auswahltransistoren durch Wortleitungen W1, W2 und W3 reihenweise miteinander verbunden sind.

Fig. 6 zeigt eine Draufsicht auf ein Speicherzellenfeld mit Digitleitungen D1 bis D4, Bitleitungen B1 bis B3 und Wortlei-tungen W1 bis W4 der in Fig. 5 dargestellten Art, wobei hier lediglich jeweils eine zusätzliche Digitleitung D4, eine zu-sätzliche Bitleitung B3 und eine zusätzliche Wortleitung W4 ver-anschaulicht sind. Wird die kleinste mit der jeweils angewandten Technologie erreichbare Strukturgröße mit F² bezeichnet, so ist aus Fig. 6 zu ersehen, dass eine zwei Bit abdeckende Einheits-zelle einen Flächenbedarf von 12 F² hat, so dass eine Zellgröße jeder Speicherzelle von 6 F² vorliegt. Die Kanalbreite jedes Auswahltransistors ist dabei durch F gegeben, wie dies aus der Zuordnung der zu einem Ground-Diffusionsgebiet GD führenden Verbindungsleitung C in Bezug auf die jeweiligen Wortleitungen W1 bis W4 zu ersehen ist. In dieses Ground-Diffusionsgebiet GD sind jeweils im Bereich unterhalb der einzelnen Verbindungsleitungen C und auf der zu der jeweiligen Verbindungsleitung C gegenüber-liegenden Seite der entsprechenden Wortleitung Drainzone bzw. Source zone eingebracht.

Eine MRAM-Anordnung sollte möglichst rasch zu schreiben und zu lesen sein, also einen kleinen Innenwiderstand haben.

Es ist daher Aufgabe der vorliegenden Erfindung eine MRAM-Anordnung zu schaffen, bei der bei möglichst geringem Flächenbedarf für eine Speicherzelle, also bei einem Flächenbedarf von höchstens 6 F², der Innenwiderstand vermindert ist.

Diese Aufgabe wird bei einer MRAM-Anordnung der eingangs genannten Art erfindungsgemäß dadurch gelöst, dass jeweils ein Auswahltransistor mehreren MTJ-Speicherzellen so zugeordnet ist, dass seine Kanalweite durch die Anzahl der ihm zugewiesenen MTJ-Speicherzellen bestimmbar ist. Dabei kann ein Auswahltransistor auch einer Vielzahl von Speicherzellen zugewiesen sein.

Bei der erfindungsgemäßen MRAM-Anordnung ist vorzugsweise ein Ground-Diffusionsgebiet jeweils einem Auswahltransistor zugeordnet. Dabei kann das Ground-Diffusionsgebiet sich fingerförmig unterhalb der jeweiligen Plattenleitungen erstrecken oder auch insgesamt im Wesentlichen rechteckförmig ausgebildet sein. Schließlich werden bei der erfindungsgemäßen MRAM-Anordnung die Plattenleitungen sowie die Verbindungsleitungen zwischen den jeweiligen Plattenleitungen und zugehörigen Auswahltransistoren vorzugsweise aus polykristallinem Silizium hergestellt. Selbstverständlich können für diese. Leitungen aber auch andere Materialien gewählt werden. Die Bitleitungen bestehen vorzugsweise aus Kupfer. Die MTJ-Zellen sind in üblicher Weise aufgebaut.

Bei der erfindüngsgemäßen MRAM-Anordnung kann die Kanalweite des Auswahltransistors erheblich vergrößert werden. Dies bedeutet, dass der Innenwiderstand reduziert ist, so dass Verlustleistungen vermindert sind und ein schnelles Schreiben und Lesen gewähr-leistet ist. Bei der Realisierung der erfindungsgemäßen MRAM-Anordnung entsteht kein Platzverlust.

Wesentlich an der vorliegenden Erfindung ist also die Zuordnung nur eines Auswahltransistors zu mehreren MTJ-Speicherzellen, was eine Vergrößerung der Kanalweite und damit eine Verminderung des Innenwiderstandes erlaubt.

Nachfolgend wird die Erfindung anhand der Zeichnungen näher erläutert. Es zeigen:
- Fig. 1: eine schematische perspektivische Darstellung der erfindungsgemäßen MRAM-Anordnung nach einem Ausführungsbeispiel,
- Fig. 2: eine Draufsicht auf die MRAM-Anordnung des Ausführungsbeispiels der Erfindung,
- Fig. 3: eine MTJ-Speicherzelle mit einem Auswahltransistor bei einem Schreibvorgang,
- Fig. 4: die MTJ-Speicherzelle von Fig. 3 bei einem Lesevorgang,
- Fig. 5: ein Speicherzellenfeld mit MTJ-Speicherzellen in Perspektive, und
- Fig. 6: eine Draufsicht auf eine Fig. 5 entsprechende bestehende MRAM-Anordnung.

Die Fig. 3 bis 6 sind bereits eingangs erläutert worden.

In den Figuren werden einander entsprechende Bauteile jeweils mit den gleichen Bezugszeichen versehen.

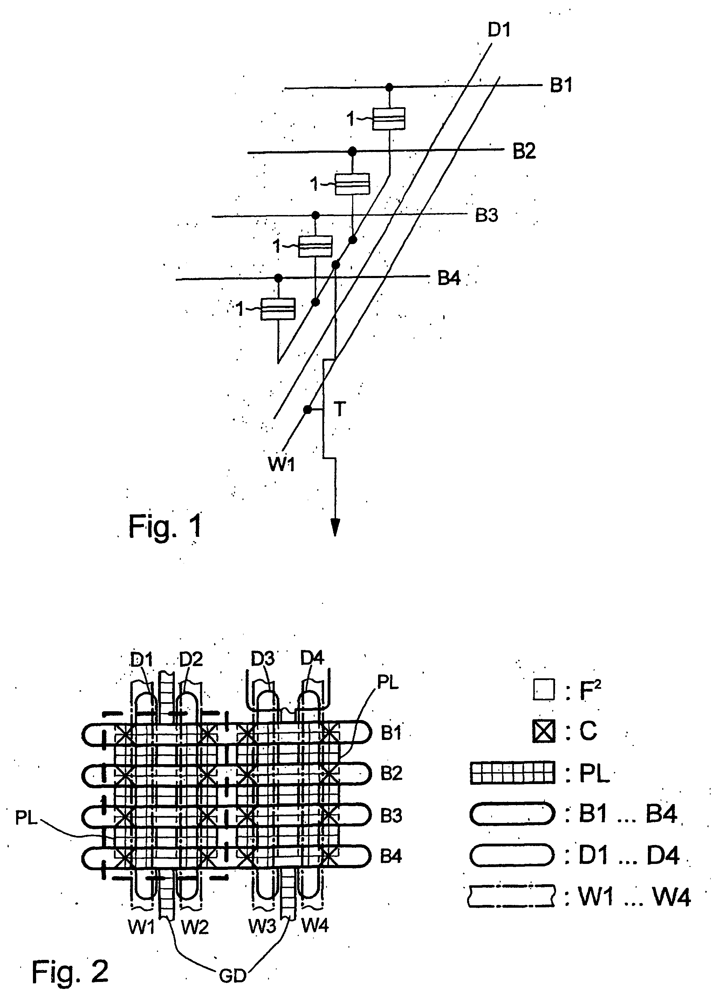

Fig. 1 zeigt in einem Blockschaltbild die erfindungsgemäße MRAM-Anordnung, bei der in einem Speicherzellenfeld mit Bitleitungen B1 bis B4 aus beispielsweise Kupfer und einer Digitleitung D1 aus beispielsweise Kupfer oder Aluminium, vier MTJ-Speicherzellen 1 einem Auswahltransistor T zugeordnet sind; der mit seiner Gate-Elektrode mit einer Wortleitung W1 verbunden ist. Durch diese "Shared Select"-Gestaltung des Auswähltransistors T ist es möglich, dessen Kanalweite ohne Verringerung der Abmessungen der Speicherzellen zu vergrößern, so dass der Auswahltransistor einen niedrigen Innenwiderstand hat.

Diese Vergrößerung der Kanalweite ist aus Fig. 2 zu ersehen, in der eine Draufsicht auf ein Ausführungsbeispiel der erfindungsgemäßen MRAM-Anordnung gezeigt ist. Zwar sind hier die einzelnen Plattenleitungen PL wieder über mehrere Verbindungsleitungen C, die jeweils unterhalb den entsprechenden Bitleitungen B1 bis B4 liegen, mit Drain bzw. Source des Transistors T verbunden. Die Plattenleitungen PL und die Verbindungsleitungen C. können beispielsweise aus dotiertem polykristallinem Silizium bestehen. Der Transistor T hat jedoch eine Kanalweite von 7 F, die durch die Erstreckung der Ground-Diffusion GD unterhalb des Bereiches zwischen der Bitleitung B1 und der Bitleitung B4 gegeben ist. Damit liegt eine effektive Kanalweite/Bit von (7/4) F vor. Allgemein beträgt bei diesem Ausführungsbeispiel die effektive Kanalweite/Bit der Auswahltransistoren [(2n - 1)/n] · F, wenn mit n die Anzahl der MTJ-Speicherzellen bezeichnet wird, die einem Auswahltransistor zugeordnet sind.

Die Zellgröße beträgt, wie aus Fig. 2 zu ersehen ist, 8 F · 6 F = 48 F² für acht Bits, so dass sich für ein Bit eine Zellgröße der Speicherzelle von 6 F² ergibt. Mit anderen Worten, trotz der erheblich vergrößerten Kanalweite des Auswahltransistors steigt der, Platzbedarf nicht an.

Die Verwendung nur eines Auswahltransistors für mehrere MTJ-Speicherzellen stellt für das Schreiben kein Problem dar, da hier der Auswahltransistor ohnehin abgeschaltet ist, wie dies anhand von Fig. 3 erläutert wurde.

### Bezugszeichenliste

- 1: MTJ-Speicherzelle
- 2: Doppelpfeil für Magnetisierungsrichtung in weichmagnetischer Schicht
- 3: Pfeil für Magnetisierungsrichtung in hart-magnetischer Schicht
- I₀: Programmierungsstrom in Bitleitung
- Iₕ: Programmierungsstrom in Digitleitung
- H₀: Magnetfeld von Programmierungsstrom I₀ in Bitleitung
- Hₕ: Magnetfeld von Programmierungsstrom Iₕ in Digitleitung
- BL, BL1 bis B4: Bitleitungen
- PL: Plattenleitung
- C: Verbindungsleitung
- T: Auswahltransistor
- Iₛ: Sense-Strom
- D, D1 bis D4: Digitleitungen
- W, W1 bis W4: Wortleitungen
- F: kleinste Strukturgröße
- DR: Treiber
- DEC: Decoder
- GD: Ground-Diffusionsgebiet

## Patentansprüche

1. MRAM-Anordnung mit einer Vielzahl von in einem Speicherzellenfeld matrixartig vorgesehenen MTJ-Speicherzellen (1), die jeweils zwischen in einer ersten Richtung des Speicherzellenfeldes verlaufenden Bitleitungen (B1 bis B4) und Plattenleitungen (PL) liegen, und mit an die Plattenleitungen (PL) angeschlossenen Auswahltransistoren (T), deren Gateanschlüsse mit Wortleitungen (W1 bis W4) verbunden sind und die mit ihren Source-Drain-Strecken zwischen den Plattenleitungen (PL) und Bezugspotential (Ground) liegen, wobei jeweils ein Auswahltransistor (T) mehreren MTJ-Speicherzellen (1) zugeordnet ist,
**dadurch gekennzeichnet,**
**dass** im Abstand von den MTJ-Speicherzellen (1) diesen reihenweise zugeordnete und sich im Speicherzellenfeld in einer zweiten Richtung erstreckende Digitleitungen (D1 bis D4) zur Programmierung der MTJ-Speicherzellen (1), vorgesehen sind, wobei die zweite Richtung im Wesentlichen senkrecht zur ersten Richtung ist, und
**dass** die effektive Kanalweite des Auswahltransistors (T) durch [(2n-1)/n] · F gegeben ist, wobei n die Anzahl der MTJ-Speicherzellen (1), die jeweils einem Auswahltransistor (T) zugeordnet sind, und F die kleinste mit der jeweils angewandten Technologie erreichbare Strukturgröße bezeichnen.

2. MRAM-Anordnung nach Anspruch 1,
**dadurch gekennzeichnet,**
**dass** ein Ground-Diffusionsgebiet (GD) jedem Auswahltransistor (T) zugeordnet ist.

3. MRAM-Anordnung nach Anspruch 2,
**dadurch gekennzeichnet,**
**dass** das Ground-Diffusionsgebiet (GD) sich fingerförmig unterhalb der Plattenleitungen (PL) erstreckt.

4. MRAM-Anordnung nach Anspruch 2,
**dadurch gekennzeichnet,**
**dass** das Ground-Diffusionsgebiet (G) im Wesentlichen rechteckförmig ausgebildet ist.

5. MRAM-Anordnung nach einem der Ansprüche 1 bis 4,
**dadurch gekennzeichnet,**
**dass** die Plattenleitungen (PL) und Verbindungsleitungen (C) zwischen den Plattenleitungen (PL) und den Transistoren (T) aus polykristallinem Silizium gebildet sind.

6. MRAM-Anordnung nach einem der Ansprüche 1 bis 5,
**dadurch gekennzeichnet,**
**dass** die Bitleitungen (B1 bis B4) aus Kupfer und die Digitleitung (D1) aus Kupfer oder Aluminium bestehen.

## Claims

1. MRAM arrangement having a multiplicity of MTJ memory cells (1) which are provided in a matrix-like manner in a memory cell array and are in each case located between bit lines (B1 to B4), which run in a first direction of the memory cell array, and plate lines (PL), and having selection transistors (T) which are connected to the plate lines (PL), whose gate terminals are connected to word lines (W1 to W4) and which are located with their source-drain paths between the plate lines (PL) and reference-ground potential (ground), a selection transistor (T) in each case being assigned to a plurality of MTJ memory cells (1),
**characterized**
**in that**, at a distance from the MTJ memory cells (1), digit lines (D1 to D4) for programming the MTJ memory cells (1) are provided, which digit lines are assigned to said MTJ memory cells row by row and extend in a second direction in the memory cell array, the second direction being essentially perpendicular to the first direction, and
**in that** the effective channel width of the selection transistor (T) is given by [(2n-1)/n]·F where n denotes the number of memory cells (1) which are in each case assigned to a selection transistor (T) and F denotes the smallest feature size that can be achieved with the technology respectively employed.

2. MRAM arrangement according to Claim 1,
**characterized**
**in that** a ground diffusion region (GD) is assigned to each selection transistor (T).

3. MRAM arrangement according to Claim 2,
**characterized**
**in that** the ground diffusion region (GD) extends in finger-shaped fashion below the plate lines (PL).

4. MRAM arrangement according to Claim 2,
**characterized**
**in that** the ground diffusion region (G) is of essentially rectangular design.

5. MRAM arrangement according to one of Claims 1 to 4,
**characterized**
**in that** the plate lines (PL) and connecting lines (C) between the plate lines (PL) and the transistors (T) are formed from polycrystalline silicon.

6. MRAM arrangement according to one of Claims 1 to 5, **characterized**
**in that** the bit lines (B1 to B4) are composed of copper and the digit line (D1) is composed of copper or aluminium.

## Revendications

1. Dispositif MRAM ayant une pluralité de cellules (1) de mémoire MTJ prévues en forme de matrice dans une champ de cellules de mémoire se trouvant, respectivement, entre des lignes (B1 à B4) de bits s'étendant dans une première direction du champ de cellules de mémoire et des lignes (PL) de plaques et comprenant des transistors (T) de sélection, qui sont reliés aux lignes (PL) de plaques, dont les bornes de grille sont reliées à des lignes (W1 à W4) de mots et qui sont interposés par leurs sections de source-drain entre les lignes de plaques et le potentiel de référence (terre), respectivement un transistor (T) de sélection étant associé à plusieurs cellules (1) de mémoire MTJ,
**caractérisé**
**en ce qu'**il est prévu, à distance des cellules (1) de mémoire MTJ associées à celles-ci par rangées et s'étendant dans le champ de cellules de mesure dans une deuxième direction, des lignes (D1 à D4) de chiffres pour la programmation des cellules (1) de mémoire MTJ, la deuxième direction étant sensiblement perpendiculaire à la première direction et en ce que la largeur efficace du canal du transistor (T) de sélection est donnée par [(2n - 1) / n] • F, n étant le nombre des cellules (1) de mémoire MTJ qui sont associées, respectivement, à un transistor (T) de sélection et F étant la dimension de structure la plus petite que l'on peut obtenir par la technologie qui est utilisée.

2. Dispositif MRAM suivant la revendication 1,
**caractérisé**
**en ce qu'**une terre-zone de diffusion (GD) est associée à chaque transistor (T) de sélection.

3. Dispositif MRAM suivant la revendication 2,
**caractérisé**
**en ce que** la terre-zone de diffusion (GD) s'étend sous la forme de doigt en dessous des lignes (PL) de plaques.

4. Dispositif MRAM suivant la revendication 2, **caractérisé en ce que** la zone de terre-diffusion (G) est sensiblement rectangulaire.

5. Dispositif MRAM suivant l'une des revendications 1 à 4,
**caractérisé**
**en ce que** les lignes (PL) de plaques et les lignes C de liaison comprises entre les lignes (PL) de plaques et les transistors (T) sont en silicium polycristallin.

6. Dispositif MRAM suivant l'une des revendications 1 à 5,
**caractérisé**
**en ce que** les lignes (B1 à B4) de bits sont en cuivre et les lignes (D1) de chiffres sont en cuivre ou en aluminium.
